# EUROPÄISCHE PATENTSCHRIFT

(11) **EP 1 933 379 B1**
(45) Veröffentlichungstag und Bekanntmachung des Hinweises auf die Patenterteilung: **22.05.2013**
(21) Anmeldenummer: 07024104.7
(22) Anmeldetag: 12.12.2007
(51) Int. Cl.: H01L 25/07, H01L 23/48, H01L 23/498, H01R 13/24

(54) **Leistungshalbleitermodul mit Kontaktfedern**
Power semiconductor module with contact springs
Module semi-conducteur de puissance doté de ressorts de contact

(30) Priorität: 13.12.2006 DE 102006058692
(43) Veröffentlichungstag der Anmeldung: 18.06.2008
(73) Patentinhaber: SEMIKRON Elektronik GmbH & Co. KG, 90431 Nürnberg (DE)
(72) Erfinder: Popp, Rainer, 91580 Petersaurach (DE); Manz, Yvonne, 91085 Weisenberg (DE)

(56) Entgegenhaltungen:
- EP-A- 1 648 029
- DE-A1- 10 306 643
- DE-A1-102004 025 609
- DE-A1-102005 017 849
- DE-A1-102005 024 900

## Beschreibung

Die Erfindung beschreibt ein Leistungshalbleitermodul in Druckkontaktausführung mit mindestens einem als Kontaktfeder ausgebildeten Anschlusselement. Einen Ausgangspunkt der Erfindung bilden Leistungshalbleitermodule wie sie beispielhaft aus der DE 197 19 703 A1 bekannt sind.

Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.

Ebenfalls bekannt sind druckkontaktierte Leistungshalbleitermodule, wie sie aus der DE 42 37 632 A1 bekannt sind. In dieser Druckschrift weist die Druckeinrichtung ein stabiles, vorzugsweise metallisches, Druckelement zum Druckaufbau, ein elastisches Kissenelement zur Druck Speicherung und ein Brückenelement zur Druckeinleitung auf gesonderte Bereiche der Substratoberfläche auf. Das Brückenelement ist vorzugsweise ausgestaltet als ein Kunststoffformkörper mit einer dem Kissenelement zugewandten i Fläche, von der eine Vielzahl von Druckfingern in Richtung der Substratoberfläche ausgehen.

Mittels einer derartigen Druckeinrichtung wird das Substrat auf ein Kühlbauteil gedrückt und somit der Wärmeübergang zwischen dem Substrat und dem Kühlbauteil dauerhaft sicher hergestellt. Das elastische Kissenelement dient hierbei der Aufrechterhaltung konstanter Druckverhältnisse bei unterschiedlichen thermischen Belastungen und über den gesamten Lebenszyklus des Leistungshalbleitermoduls.

Aus der DE 10 2004 025 609 A1 ist ein Leistungshalbleitermodul mit einer Grundplatte und als Kontaktfedern ausgebildeten Hilfsanschlusselementen bekannt. Gemäß dieser Druckschrift werden die Kontaktfedern zur sicheren elektrischen Kontaktierung mittels eines Deckels mit Druck beaufschlagt. Hierbei sind die Kontaktfedern in einer nicht detailliert offen gelegten Halterung des Gehäuses angeordnet.

Aus der spät veröffentlichten DE 10 2006 006 421 A1 ist ein Leistungshalbleitermodul mit mindestens einem Anschlusselement, das als eine Kontaktfeder mit einer ersten Kontakteinrichtung, einem federnden Abschnitt und einer zweiten Kontakteinrichtung ausgebildet ist, bekannt. Hierbei weist ein erster Kunststoffformkörper einen senkrecht zum Substrat angeordneten Schacht zur Aufnahme eines Anschlusselements auf. Dieser Schacht weist seinerseits eine seitliche Ausnehmung zur verdrehsicheren Anordnung des Anschlusselements und eine Aussparung für einen zugeordneten Teilkörper eines zweiten Kunststoffformkörper auf, wobei dieser Teilkörper ebenfalls eine seitliche Ausnehmung und auf der dem Substrat abgewandten Seite eine Ausnehmung für die erste Kontakteinrichtung des Anschlusselements aufweist und diese hier hindurch reicht.

Die DE 10 2005 024 900 A1 offenbart ein Leistungshalbleitermodul mit in einem Rahmen als Teil eines Gehäuse und hierin eingesetzten Federanschlusselementen, welche jeweils durch in dem Rahmen angeordnete Öffnungen frei anordenbar, ein im Inneren des Gehäuses angeordnetes Substrat, kontaktieren. Hierbei ist das jeweilige Federanschlusselement ausgestaltet mit einem gewendelten, federwirksamen Abschnitt und einem stiftartigen Kontaktabschnitt zur Kontaktierung des Substrats. Ein Herausfallen des jeweiligen Federanschlusselements wird durch Variation des Durchmessers der Wendel, also des federwirksamen Abschnitts in Form zweier sich einander anschließender Wendel unterschiedlichen Durchmessers, und entsprechender Anordnung dieser Wendel in einer zugeordneten Ausnehmung mit zwei unterschiedlichen Durchmessern im Gehäuse, erreicht.

Der Erfindung liegt die Aufgabe zugrunde ein Leistungshalbleitermodul vorzustellen, wobei die Anschlusselemente federnd ausgebildet sind, gegen Herausfallen gesichert sind und das Leistungshalbleitermodul einer einfachen Herstellung zugänglich ist.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einem Leistungshalbleitermodul der oben genannten Art mit einem Gehäuse und einem Substrat mit mindestens einer metallischen Leiterbahn. Von mindestens einer Leiterbahn oder mindestens einer Kontaktfläche eines auf einer Leiterbahn angeordneten Leistungshalbleiterbauelements führt mindestens ein Anschlusselement aus dem Gehäuse heraus.

Mindestens eines dieser Anschlusselemente ist als Kontaktfeder mit einer ersten stiftartigen Kontakteinrichtung, einem federnden Abschnitt und einer zweiten Kontakteinrichtung ausgebildet. Das Gehäuse weist Ausnehmungen zur Anordnung der Kontaktfedern auf, wobei jede Ausnehmung eine erste und eine zweite Teilausnehmung aufweist, wobei der Durchmesser der zweiten Teilausnehmung geringer ist als die Summe aus dem Durchmesser der stiftartigen ersten Kontakteinrichtung und einer durch eine Verformung dieser ersten Kontakteinrichtung bestimmten Auslenkung. Erfindungsgemäß ist diese Verformung zwischen der zweiten Teilausnehmung und dem Substrat angeordnet, wobei die zweite Teilausnehmung zum Substrat hin gerichtet ist.

Die erfinderische Lösung wird an Hand der Ausführungsbeispiele der Fig. 1 bis 6 weiter erläutert.

Fig. 1 zeigt ein Leistungshalbleitermodul mit einer Kontaktfeder nach dem Stand der Technik.

Fig. 2 zeigt eine erste Ausgestaltung einer Kontaktfeder zur Anwendung in einem erfindungsgemäßen Leistungshalbleitermodul.

Fig. 3 zeigt eine zweite Ausgestaltung einer Kontaktfeder zur Anwendung in einem erfindungsgemäßen Leistungshalbleitermodul.

Fig. 4 zeigt eine erste Ausgestaltung einer Ausnehmung eines erfindungsgemäßen Leistungshalbleitermoduls.

Fig. 5 zeigt eine zweite Ausgestaltung einer Ausnehmung eines erfindungsgemäßen Leistungshalbleitermoduls.

Fig. 6 zeigt eine dritte Ausgestaltung einer Ausnehmung eines erfindungsgemäßen Leistungshalbleitermoduls.

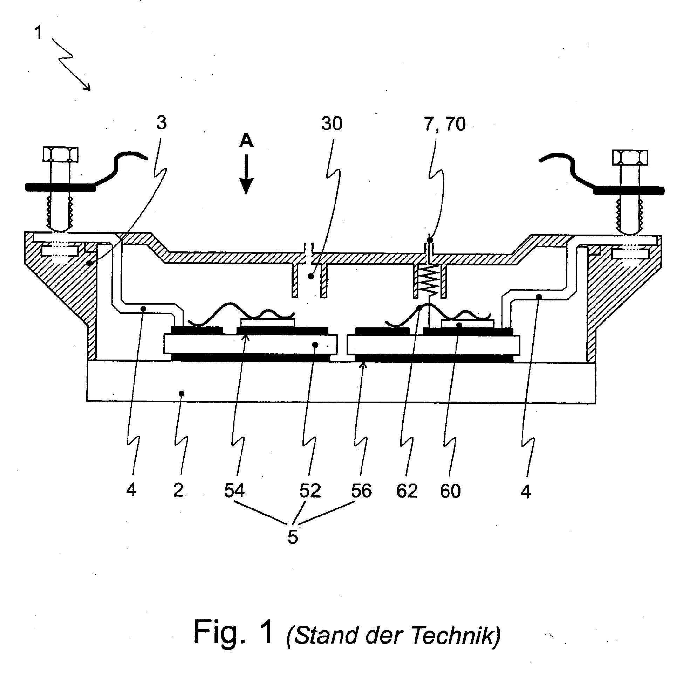

Fig. 1 zeigt ein Leistungshalbleitermodul (1) nach dem Stand der Technik. Das Leistungshalbleitermodul (1) weist eine Grundplatte (2) mit hierauf angeordneten Substraten (5), vorzugsweise ausgebildet als DCB (direct copper bonding) Substrate, auf. Das jeweilige Substrat (5) weist eine Isolierkeramik (52) mit beidseitigen Metallkaschierungen (54, 56) auf. Die Metallkaschierungen (54) im inneren des Leistungshalbleitermoduls (1) bilden durch Strukturierung eine Mehrzahl von Leiterbahnen (54) zur Anordnung schaltungsgerecht mittels Drahtbondverbindungen (62) verbundener Leistungshalbleiterbauelemente (60) aus und dienen auch als Kontaktfläche für Anschlusselemente (4, 7).

Dargestellt ist ein Leistungshalbleitermodul (1) mit der Grundplatte (2) und mit einem Gehäuse (3) welches eine Mehrzahl von Substraten (5) umschließt. Das Gehäuse weist eine Mehrzahl von Durchführungen bzw. Ausnehmungen (30) für Anschlusselemente (4, 7) zur externen Verbindung auf. Dargestellt sind hier Lastanschlusselemente (4) in Form flächiger Metallformkörper, sowie Hilfsanschlusselemente (7) in Form von Kontaktfedern (70).

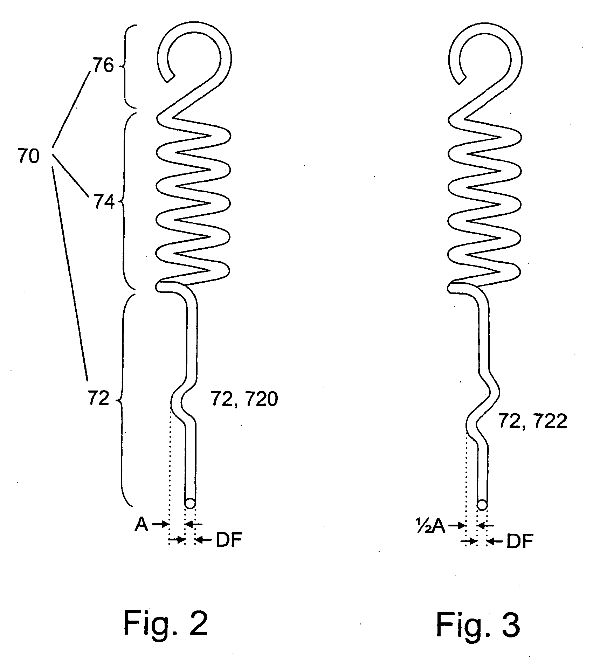

Diese Kontaktfedern (70) weisen eine erste Kontakteinrichtung zur Kontaktierung von Leiterbahnen oder auch von nicht dargestellten Kontaktflächen von Leistungshalbleiterbauelementen, einen federnden Abschnitt und eine zweite Kontakteinrichtung zur externen Verbindung auf (vgl. Fig. 2).

Diese Darstellung zeigt eine beispielhafte Ausgestaltung eines Leistungshalbleitermodul (1), wobei die folgenden hierauf basierenden erfindungsgemäßen Ausgestaltungen auch für weitere Ausbildungen von Leistungshalbleitermodulen, beispielhaft ohne Grundplatte, mit weiteren Substratvarianten oder anderen Gehäuseausbildungen geeignet sind. Auch kann es speziell bei Leistungshalbleitermodulen mit geringer Leistung bevorzugt sein, nicht nur wie hier dargestellt die Hilfsanschlüsse, sondern auch die Lastanschlüsse mit Kontaktfedern auszubilden.

Fig. 2 zeigt eine erste Ausgestaltung einer Kontaktfeder (70) zur Anwendung in einem erfindungsgemäßen Leistungshalbleitermodul (1) mit einer ersten Kontakteinrichtung (72) einem federnden Abschnitt (74) und einer zweiten Kontakteinrichtung (76). Hierbei ist diese Kontaktfeder (70) erfindungsgemäß derart weitergebildet, dass ihre erste Kontakteinrichtung (72) mit einem Durchmesser (DF) eine bogenförmige Verformung (720) aufweist. Durch diese Verformung wird die Auslenkung (A) der Kontakteinrichtung (72) bestimmt.

Fig. 3 zeigt eine zweite Ausgestaltung einer Kontaktfeder (70) zur Anwendung in einem erfindungsgemäßen Leistungshalbleitermodul (1): Hierbei ist die Kontaktfeder (70) erfindungsgemäß derart weitergebildet, dass ihre erste Kontakteinrichtung (72) mit einem Durchmesser (DF) eine S-förmige Verformung (722) in einer Ebene aufweist. Hierdurch wird die Auslenkung (A) der Kontakteinrichtung bestimmt durch die beiden vorzugsweise gleichen Teilauslenkungen (1/2 A).

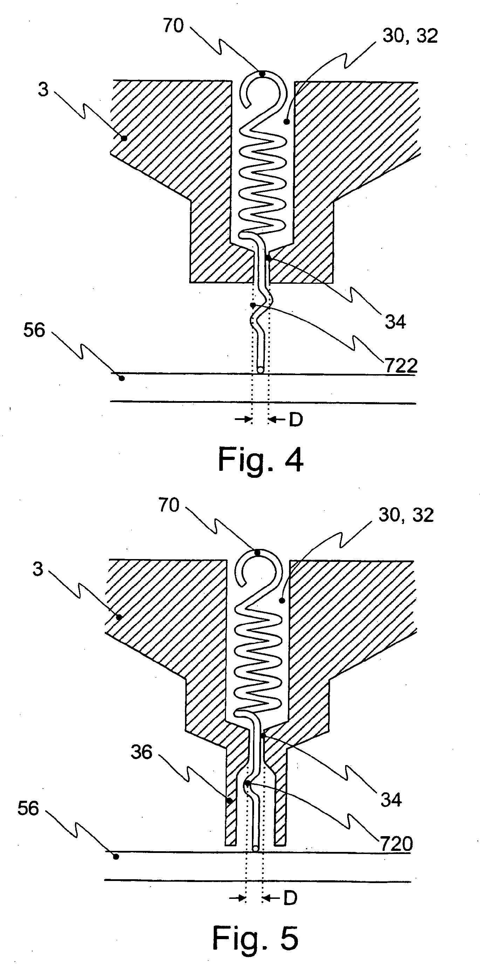

Fig. 4 zeigt eine erste Ausgestaltung einer Ausnehmung (30) eines erfindungsgemäßen Leistungshalbleitermoduls (1) mit darin angeordneter Kontaktfeder (70). Die Ausnehmung (30) ist Teil des Gehäuse (3) und derart ausgebildet, dass in ihrer dem Äußeren des Leistungshalbleitermoduls zugewandten ersten Teilausnehmung (32) der federnde Abschnitt (74) wie auch ein wesentlicher Teil der zweiten Kontakteinrichtung (76) angeordnet sind. Die stiftartig ausgebildete erste Kontakteinrichtung (72) ragt durch eine zweite Teilausnehmung (34) der Ausnehmung (30) des Gehäuses (3) hindurch zur Kontaktstelle auf einer Leiterbahn (54) oder einem Leistungshalbleiterbauelement (60). In dem Bereich unterhalb der Ausnehmung (30) ist die S-förmige Verformung (722) der ersten Kontakteinrichtung (72) angeordnet.

Die beiden Teilauslenkungen (722, vgl. Fig. 3) sind hierbei derart gestaltet, dass die Summe aus dem Durchmesser (DF) der Kontakteinrichtung (72) und den beiden Auslenkungen (1/2 A) größer ist als der Durchmesser (D) der zweiten Teilausnehmung (34). Somit kann durch eine gewisse Kraft die Kontaktfeder (70) in Richtung des Substrats (5) in das Leistungshalbleitermodul (1) eingesetzt werden, ohne dass sie durch ihr Eigengewicht wieder herausfallen kann.

Fig. 5 zeigt eine zweite Ausgestaltung einer Ausnehmung (30) eines erfindungsgemäßen Leistungshalbleitermoduls (1) mit darin angeordneter Kontaktfeder (70). Die Ausnehmung (30) ist wiederum Teil des Gehäuse (3) und derart ausgebildet, dass in ihrem dem Äußeren des Leistungshalbleitermoduls (1) zugewandten ersten Teilausnehmung der federnde Abschnitt (74) wie auch ein wesentlicher Teil der zweiten Kontakteinrichtung (76) angeordnet sind. Die stiftartig ausgebildete erste Kontakteinrichtung (72) ragt durch eine zweite Teilausnehmung (34) der Ausnehmung (30) des Gehäuses (3) hindurch zur Kontaktstelle auf einer Leiterbahn (54). In dem Bereich unterhalb der zweiten Teilausnehmung (34) ist die bogenförmige Verformung (720) der ersten Kontakteinrichtung (72) angeordnet.

Die weitere Erstreckung (36), mit einem größeren Durchmesser als die zweite Teilausnehmung, der Ausnehmung (30) reicht noch weiter in Richtung des Substrats (5) um elektrischen Anforderungen, beispielhaft an Luft- und Kriechstrecken im Inneren des Leistungshalbleitermoduls (1) gerecht zu werden.

Die Auslenkung (720, vgl. Fig. 2) ist hierbei derart gestaltet, dass die Summe aus dem Durchmesser (DF) der Kontakteinrichtung (72) und der Auslenkung (A) größer ist als der Durchmesser (D) der zweiten Teilausnehmung (34). Somit kann durch eine gewisse Kraft die Kontaktfeder (70) in Richtung des Substrats (5) in das Leistungshalbleitermodul (1) eingesetzt werden, ohne dass sie durch ihr Eigengewicht wieder herausfallen kann.

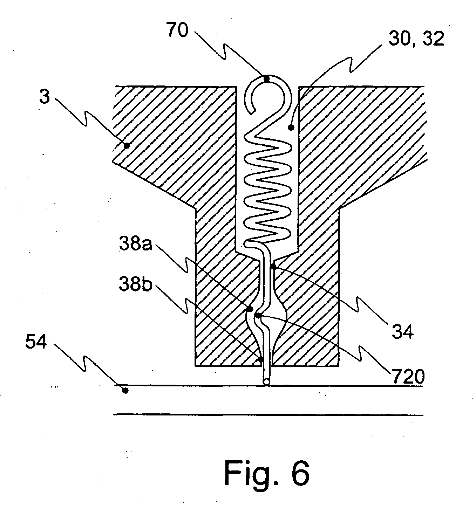

Fig. 6 zeigt eine dritte Ausgestaltung einer Ausnehmung (30) eines erfindungsgemäßen Leistungshalbleitermoduls (1) mit darin angeordneter Kontaktfeder (70). Die Ausnehmung (30) als Teil des Gehäuses (3) ist wiederum derart ausgebildet, dass in ihrem dem Äußeren des Leistungshalbleitermoduls (1) zugewandten ersten Teilausnehmung (32) der federnde Abschnitt (74) wie auch ein wesentlicher Teil der zweiten Kontakteinrichtung (76) angeordnet sind.

Die stiftartig ausgebildete erste Kontakteinrichtung (72) ragt durch eine zweite Teilausnehmung (34) der Ausnehmung (30) des Gehäuses (3) hindurch zur Kontaktstelle auf einer Leiterbahn (54). In dem Bereich unterhalb der Teilausnehmung (34) ist die bogenförmige Verformung (720) der ersten Kontakteinrichtung (72) spannungsfrei in einer weiteren Teilausnehmung (38a) mit größerem Durchmesser als derjenige der zweiten Teilausnehmung (34) angeordnet. An diese Teilausnehmung schließt sich eine weitere Teilausnehmung (38b) an, die einen geringeren Durchmesser als die zweite Teilausnehmung (34) aufweist und der präzisen Führung der ersten Kontakteinrichtung relativ zur Kontaktstelle auf der Leiterbahn (54) oder dem Leistungshalbleiterbauelement dient.

Die Auslenkung (720, vgl. Fig. 2) ist hierbei wiederum derart gestaltet, dass die Summe aus dem Durchmesser (DF) der Kontakteinrichtung (72) und der Auslenkung (A) größer ist als der Durchmesser (D) der zweiten Teilausnehmung (34). Somit kann durch eine gewisse Kraft die Kontaktfeder (70) in Richtung des Substrats (5) in das Leistungshalbleitermodul (1) eingesetzt werden, ohne dass sie durch ihr Eigengewicht wieder herausfallen kann.

## Patentansprüche

1. Leistungshalbleitermodul (1) mit einem Gehäuse (3), einem Substrat (5) mit mindestens einer metallischen Leiterbahn (54), und mindestens einem von einer Leiterbahn (54) oder einer Kontaktfläche eines auf einer Leiterbahn (54) angeordneten Leistungshalbleiterbauelements (60) nach außen führenden Anschlusselement (4, 7),
wobei das Anschlusselement (7) als Kontaktfeder (70) mit einer ersten Kontakteinrichtung (72), einem federnden Abschnitt (74) und einer zweiten Kontakteinrichtung (76) ausgebildet ist,
wobei das Gehäuse (3) eine Ausnehmungen (30) mit einer ersten und einer zweiten Teilausnehmung (32, 34) zur Anordnung der Kontaktfeder (70) aufweist, die erste Kontakteinrichtung (72) der Kontaktfeder (70) stiftartig ausgebildet ist, wobei die Ausnehmung (30) derart ausgebildet its, dass in ihrer dem Äußeren des Leistungshalbleitermoduls zugewandten ersten Teilausnehmung (32) der federnde Abschnitt (74) wie auch ein wesentlicher Teil der zweiten Kontakteinrichtung (76) angeordnet sind, wobei die stiftartig ausgebildete erste Kontakteinrichtung (72) durch eine zweite Teilausnehmung (34) der Ausnehmung (30) des Gehäuses (3) ragt, wobei der Durchmesser (D) der zweiten Teilausnehmung (34) geringer ist als die Summe aus dem Durchmesser (DF) der stiftartigen ersten Kontakteinrichtung (72) und der durch eine Verformung (720, 722) dieser ersten Kontakteinrichtung (72) bestimmten Auslenkung (A), und wobei die Verformung (720, 722) zwischen der zweiten Teilausnehmung (34) und dem Substrat (5) angeordnet ist.

2. Leistungshalbleitermodul nach Anspruch 1,
wobei die Verformung (720) bogenförmig ausgebildet ist und die Stärke dieser Verformung (720) die Auslenkung (A) bestimmt.

3. Leistungshalbleitermodul nach Anspruch 1,
wobei die Verformung (722) S-förmig in einer Ebene ausgebildet ist und jede so gebildete Teilauslenkung (1/2 A) hälftig zur Auslenkung (A) beiträgt.

## Claims

1. Power semiconductor module (1) having a housing (3), a substrate (5) with at least one metal strip conductor (54), and at least one terminal element (4, 7) leading outwardly from a strip conductor (54) or a contact surface of a power semiconductor component (60) arranged on a strip conductor (54),
wherein the terminal element (7) is designed as a contact spring (70) having a first contact device (72), a spring section (74) and a second contact device (76),
wherein the housing (3) has a recess (30) with first and second partial recesses (32, 34) for arrangement of the contact spring (70), the first contact device (72) of the contact spring (70) is pin-shaped, wherein the recess (30) is designed in such a way that in its first partial recess (32) facing towards the exterior of the power semiconductor module are arranged the spring section (74) as well as a substantial portion of the second contact device (76), wherein the pin-shaped first contact device (72) extends through a second partial recess (34) of the recess (30) of the housing (3), wherein the diameter (D) of the second partial recess (34) is smaller than the sum of the diameter (DF) of the pin-shaped first contact device (72) and the deflection (A) which is determined by a deformation (720, 722) of this first contact device (72), and wherein the deformation (720, 722) is arranged between the second partial recess (34) and the substrate (5).

2. Power semiconductor module according to claim 1,
wherein the deformation (720) is of arcuate shape and the size of this deformation (720) determines the deflection (A).

3. Power semiconductor module according to claim 1,
wherein the deformation (722) is S-shaped in one plane and each partial deflection (1/2 A) formed in this way contributes half to the deflection (A).

## Revendications

1. Module (1) semi-conducteur de puissance comportant un boîtier (3), un substrat (5) avec au moins une piste métallique (54), et au moins un élément de connexion (4, 7) menant vers l'extérieur depuis une piste (54) ou une surface de contact d'un composant (60) semi-conducteur de puissance disposé sur une piste (54),
où l'élément de connexion (7) est réalisé comme ressort de contact (70) avec un premier dispositif de contact (72), une section élastique (74) et un deuxième dispositif de contact (76),
où le boîtier (3) présente un évidement (30) avec un premier et un deuxième évidement partiel (32, 34) pour le logement du ressort de contact (70), le premier dispositif de contact (72) du ressort de contact (70) étant réalisé en forme de goupille, l'évidement (30) étant réalisé de telle manière que la section élastique (74) ainsi qu'une grande partie du deuxième dispositif de contact (76) sont disposées dans son premier évidement partiel (32) dirigé vers l'extérieur du module semi-conducteur de puissance, le premier dispositif de contact (72) en forme de goupille traversant un deuxième évidement partiel (34) de l'évidement (30) du boîtier (3), le diamètre (D) du deuxième évidement partiel (34) étant inférieur au total du diamètre (DF) du premier dispositif de contact (72) en forme de goupille et du déport (A) défini par une déformation (720, 722) dudit premier dispositif de contact (72), et la déformation (720, 722) étant disposée entre le deuxième évidement partiel (34) et le substrat (5).

2. Module semi-conducteur de puissance selon la revendication 1,
où la déformation (720) est réalisée en forme d'arc, et où l'épaisseur de ladite déformation (720) définit le déport (A).

3. Module semi-conducteur de puissance selon la revendication 1,
où la déformation (722) est réalisée en forme de S sur un plan et où chaque déport partiel (1/2 A) ainsi formé contribue pour moitié au déport (A).
